(19) Europäisches Patentamt
European Patent Office
Office européen des brevets

(11) **EP 3 153 808 A1**

(12) **EUROPEAN PATENT APPLICATION**

(43) Date of publication:
**12.04.2017 Bulletin 2017/15**

(51) Int Cl.:
*F28F 9/02* (2006.01)     *F28D 15/02* (2006.01)
*F28D 15/04* (2006.01)    *F28F 1/02* (2006.01)
*H05K 7/20* (2006.01)

(21) Application number: **15188764.3**

(22) Date of filing: **07.10.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **ABB Technology Oy
00380 Helsinki (FI)**

(72) Inventors:
• **Habert, Mathieu
5405 Baden-Daettwil (CH)**

• **Agostini, Bruno
5405 Baden-Daettwil (CH)**
• **Torresin, Daniele
5405 Baden-Daettwil (CH)**
• **Agostini, Francesco
5405 Baden-Daettwil (CH)**
• **Riedel, Gernot
5405 Baden-Daettwil (CH)**
• **Leppänen, Veli-Matti
00380 Helsinki (FI)**

(74) Representative: **Kolster Oy Ab
Iso Roobertinkatu 23
PO Box 148
00121 Helsinki (FI)**

(54) **A COOLING APPARATUS AND A MANUFACTURING METHOD**

(57) The invention relates to a cooling apparatus (1) comprising tubes (4) containing a plurality of channels (8), a first manifold (2) and a second manifold (3) in the second end (7) which provides a fluid path between predetermined channels (8) of the tubes (4). In order to obtain a cooling apparatus providing excellent cooling, the first (2) and second (3) manifolds are solid blocks providing channel loops (10, 11), and the channels (8) of the tubes (4) are connected by the channel loops (10, 11) to other predetermined channels (8) of the tubes (4).

FIG. 1

EP 3 153 808 A1

**Description**

BACKGROUND OF THE INVENTION

FIELD OF THE INVENTION

This invention relates to a cooling apparatus and to a method for manufacturing a cooling apparatus. The cooling apparatus is in particularly suitable for use in electric devices in order to cool electric components. It should, however, be observed that the cooling apparatus may be used also for other purposes.

DESCRIPTION OF PRIOR ART

Previously there is known a cooling apparatus with tubes extending between a first and second end, where a first and second manifold are arranged to provide a fluid path between groups of channels of the tubes. In the known device the manifolds are implemented as a stack of plates having openings in selected positions in order to provide the fluid paths between the groups of channels. The channels have a capillary dimension in order to provide an orientation free cooling apparatus working as a pulsating heat pipe.

With such a device working as an open loop pulsating heat pipe or a closed loop pulsating heat pipe transfer of heat can be obtained from a first end of the cooling apparatus to a second end of the cooling apparatus irrespectively of the position in which the cooling apparatus is utilized. After evacuating and filling partially the channels of the tubes with a working fluid, the fluid distributes itself in the form of liquid-vapor plugs and slugs inside the capillary dimensioned channels, transfer of heat occurs from the first end of the cooling apparatus to the second end of the apparatus.

In order to obtain a cooling apparatus working as efficiently as possible the manifolds need to be designed in such a way that the amount of disturbance can be minimized. In the known device this is, however, very difficult, and additionally assembly of the device is cumbersome due to the large number of parts.

SUMMARY OF THE INVENTION

An object of the present invention is to provide a cooling apparatus which has the capability of providing excellent cooling. This object is achieved with a cooling apparatus according to independent claim 1 and with the manufacturing method according to independent claim 11.

The possibility of connecting channels of tubes by channel loops provided by manifolds implemented as solid blocks gives a freedom of geometry to implement the channel loops with an optimal shape at the same time as the number of parts needed in the cooling apparatus can be minimized.

BRIEF DESCRIPTION OF DRAWINGS

In the following the present invention will be described in closer detail by way of example and with reference to the attached drawings, in which

Figures 1 to 3 illustrate a first embodiment of a cooling apparatus,
Figure 4 illustrates a second embodiment of a cooling apparatus, and
Figure 5 illustrates a third embodiment of a cooling apparatus.

DESCRIPTION OF AT LEAST ONE EMBODIMENT

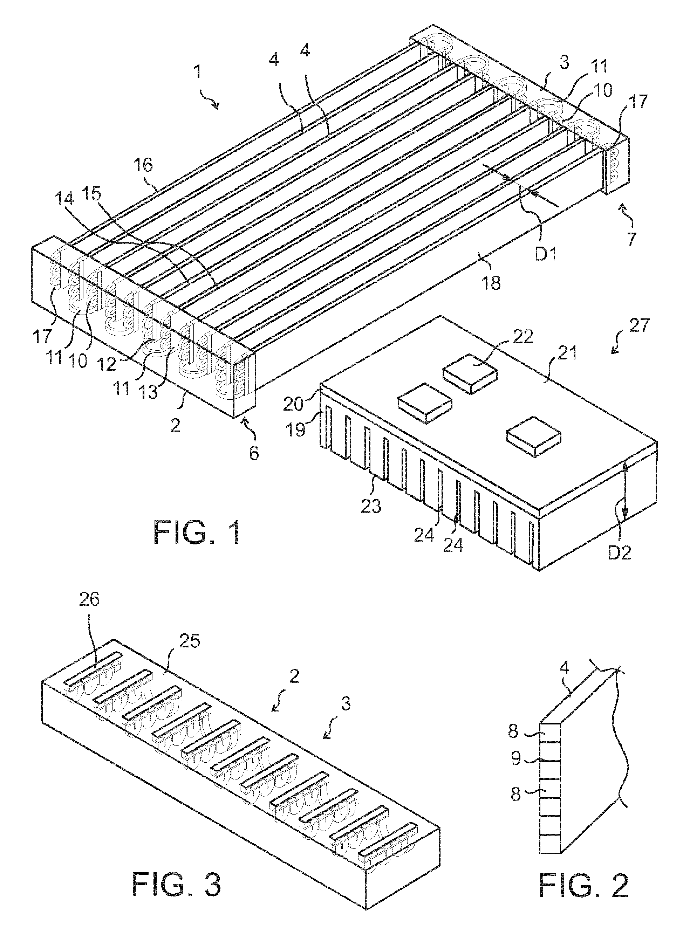

Figures 1 to 3 illustrate a first embodiment of a cooling apparatus 1. Figure 1 illustrates the cooling apparatus once assembled, Figure 2 illustrates an end view of a tube 4, and Figure 3 illustrates the side of the first 2 and second 3 manifolds to which the tubes 4 are attached. These manifolds 2 and 3 are identical parts in the illustrated example, and therefore only one manifold is shown in Figure 3. For clarity, in Figures 1 and 3 the channel loops contained in the first 2 and second 3 manifold are illustrated as if the first 2 and second 3 manifolds would be made of a transparent material, which generally is not the case in praxis.

The cooling apparatus comprises tubes 4 extending between a first end 6 and a second end 7 of the cooling apparatus 1. Each tube 4 contains a plurality of channels 8 which are separated from each other by longitudinal internal walls 9 of the respective tube. The tubes may be MPE (Multi Port Extruded) tubes, in other words tubes which have been manufactured by extrusion of aluminum, for instance. In order to facilitate that the cooling apparatus 1 works as an orientation free pulsating heat pipe, the channels 8 are capillary dimensioned. The diameter of a channel which is considered capillary depends on the fluid that is used (boiling) inside. The following formula, for instance, can be used to evaluate a suitable diameter:

$$D = (sigma/(g*(rhol-rhov)))^0.5,$$

wherein sigma is the surface tension, g the acceleration of gravity, rhov the vapour density and rhol the liquid density. This formula gives values from 1 to 3 mm for R134a (Tetrafluoroethane), R145fa and R1234ze (Tetrafluoropropene), which are fluids suitable for use in the heat exchanger illustrated in the figures.

A first manifold 2 in the first end of the cooling apparatus and a second manifold 3 in a second end of the cooling apparatus 1 provide a fluid path between predetermined channels 8 of the tubes 4 via channel loops 10 and 11. The first 2 and second 3 manifolds may be implemented as solid blocks of aluminum, for instance.

The use of solid blocks minimizes the number of parts and simplifies assembly of the cooling apparatus. Additionally the geometry, spatial arrangement and number of turns can easily be optimized within the solid blocks. As can be seen from Figure 1, in this example the blocks provide channel loops 10, 11 that have a constant cross-section and curvature. Such channel loops 10, 11 minimize flow disturbance and pressure drop. In praxis the cross-section of the channel loops may be circular, oval or even rectangular. Additionally, the cross-section (shape and dimension) of the channel loops may be the same as the cross section of the channels that are connected to each other via the channel loops.

Individual channels 8 of the tubes 4 are connected by the channel loops 10, 11 of the first 2 and of the second manifold 3 to other predetermined individual channels 8 of the tubes 4. Such a solution maximizes the number of turns on the fluid path of the cooling apparatus 1 and improves the performance. In this application the term fluid is used as a general term for the material, such as refrigerant, which is utilized within the cooling apparatus. Consequently, in some part of the cooling apparatus the fluid may be in a liquid state and in some other parts of the cooling apparatus the fluid may be in a gas state.

In the embodiment of figures 1 to 3, the first 2 and second 3 manifolds have a symmetrical design with identical channel loops, as can (partly) be seen in Figure 1. This simplifies the manufacturing process as the number of different parts is minimized.

In the embodiment of Figure 1 the first 2 and second 3 manifolds are both provided with first channel loops 10 and second channel loops 11. The first channel loops 10 provide a fluid path back and forth through the channels 8 of each single tube 4. The second channel loops 11 provide a fluid path from a last channel 12 of the fluid path of each tube 14 to a first channel 13 on the fluid path of a subsequent tube 15. The result is a cooling apparatus where all channels 8 and all channel loops 10, 11 are connected in series to provide one single fluid path through the entire cooling apparatus 1. A first end of a first channel (the lowermost in Figure 1) of a first outermost tube 16 is plugged 17 in the first end 6 of the cooling apparatus 1. Additionally a second end of a last channel (the uppermost in Figure 1) of a second outermost tube 18 is plugged 17 in Figure 1. Consequently, the cooling apparatus works as an open loop pulsating heat pipe.

Figure 1 also illustrates a base plate 27 which in some embodiments may be attached to to the tubes 4 of the cooling apparatus. Such a base plate is not necessary in all embodiments, because instead of utilizing a base plate for transferring heat to fluid in the tubes 4, a hot air stream, for instance, may be directed to pass between the tubes 4 in the first end 6 of the cooling element. The illustrated base plate 27 includes at least two layers of different materials. In this example a material of the first layer 19 has a significantly better thermal conductivity than a material of the second layer 20, however, the material of the second layer 20 has a significantly better electrical insulation capability than the material of the first layer 19. The material of the first layer 19 may include aluminum, for instance, while the second layer 20 may include a material with better electrical insulating capabilities, such as aluminium oxide ($Al_2O_3$), for instance. Though not illustrated in the figures, the base plate may be provided with more layers, such as with one or more intermediate layers of copper, graphite or graphene between the first layer 19 and the second layer 20, for instance.

In the illustrated example it is by way of example assumed that the base plate 27 is provided with a first surface 21 for receiving an electrical component 22 and with a second surface 23, which is opposite to the first surface 21, and which is provided with grooves 24 into which at least a part of the tubes 4 penetrate once the base plate 27 is attached to the cooling device.

Manufacturing of the illustrated cooling device may begin by providing tubes 4 having the channels 8, such as by extruding the tubes from aluminum. The first 2 and second 3 manifold may be manufactured by 3D printing such that they have the illustrated channel loops 10 and 11 embedded in a solid block, for instance. The inner surfaces 25 of the manifolds, which after assembly face the tubes 4, may also during 3D printing be provided with cavities 26 intended to receive ends of the tubes 4. Such 3D printing may be carried out with a material containing at least aluminum, which makes it possible to obtain a very precise desired shape for the channel loops 10 and 11. This manufacturing method also facilitates that channel loops 10 and 11 are provided at such locations that the inter-spacing D1 between the tubes 4 can be even 8 mm or less. In this way a very compact and efficient cooling apparatus can be manufactured.

The ends of the tubes 4 and/or the cavities 26 may be provided with a layer of solder such that once the tubes 4 of aluminum and the manifolds 2 and 3 are ready with the ends of the tubes 4 inside the cavities 26, the entire "package" may be placed in an oven where the solder melts and subsequently attached the tubes to the manifolds, when the package is removed from the oven and the solder cools.

If additionally a base plate is needed, this base plate 27 may be produced by 3D printing as a composite containing layers of different materials with different properties, as explained previously. 3D printing has an additional advantage in that the thickness of the base plate 27 may be maximized to thicknesses D2 well above 30 mm.

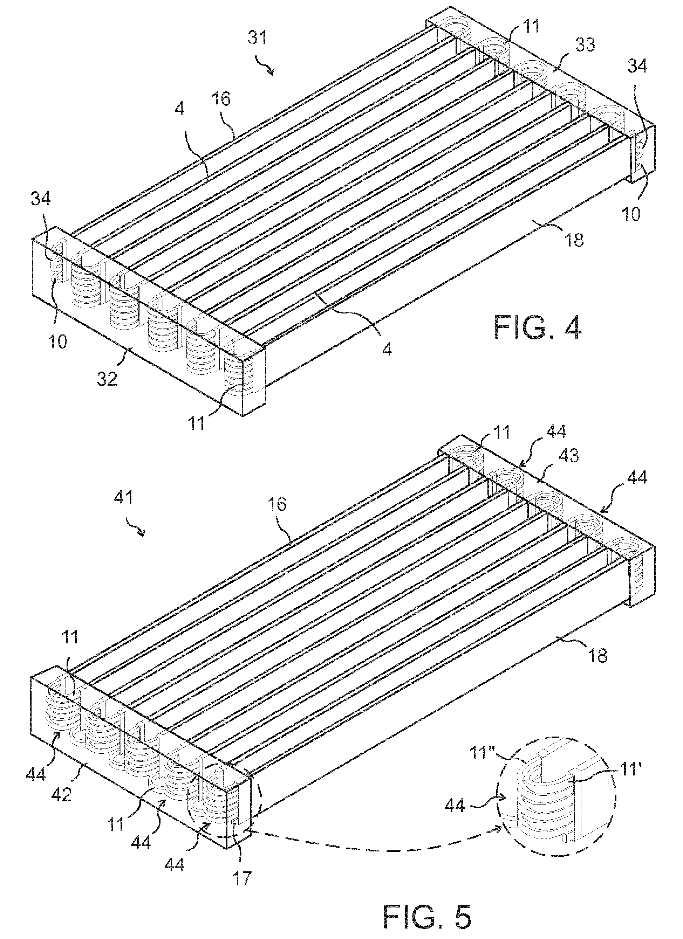

Figure 4 illustrates a second embodiment of a cooling apparatus 31. The cooling apparatus 31 of Figure 4 is very similar to the cooling apparatus 1 of Figures 1 to 3. Therefore the embodiment of Figure 4 is in the following mainly explained by pointing out the differences between these embodiments.

In Figure 4 the first 32 and second manifolds 33 have channel loops implemented in a different configuration than in the previous embodiment. In Figure 4 the first 32 and second 33 manifolds are provided with second channel loops 11 providing a fluid path from each channel 8 of each tube to one channel of an adjacent tube, except for the outermost tubes. At the first outermost tube 16 adjacent channels of the tube are interconnected in the first manifold 32 by first channel loops 10 that provide a fluid path between two adjacent channels. Additionally, at the first outermost tube 16 a third channel loop 34 in the first manifold 32 provides a fluid path between three adjacent channels of the tube. At the second outermost tube 18 adjacent channels 8 of the tube are interconnected in the second manifold 33 by first channel loops 10 that provide a fluid path between two adjacent channels. Additionally, at the second outermost tube 18 a third channel loop 34 in the second manifold 33 provides a fluid path between three adjacent channels 8 of the tube.

Similarly as in the previous embodiment the first 32 and second 33 manifolds have a symmetrical design with identical channel loops, as illustrated in Figure 4.

Figure 5 illustrates a third embodiment of a cooling apparatus. The cooling apparatus 31 of Figure 4 is very similar to the cooling apparatus 1 of the previous embodiments. Therefore the embodiment of Figure 5 is in the following mainly explained by pointing out the differences between these embodiments.

In Figure 5 the first 42 and second 43 manifolds have channel loops implemented in a different configuration than in the previous embodiments. In Figure 5 the first 42 and second 43 manifolds are provided with second channel loops 11 providing a fluid path from each channel of each tube to one channel of an adjacent tube, except for a first end of a first channel (the lowermost in Figure 5) of a first outermost tube 16 and a first end of a a first channel (the lowermost in Figure 5) of a second outermost tube 18 which are plugged 17 in a first end 6 of the cooling apparatus.

In the embodiment of Figure 5 a shoelaces configuration 44 is used in the first 42 and second 43 manifolds for the first channel loops 11 that are arranged on top of each other, as illustrated in Figure 5. An enlargement of a shoelaces configuration 44 is illustrated in the enlarged circle, from where it can be seen that the uppermost second channel loop 11' connects the right uppermost channel with the left second uppermost channel, while a neighboring second channel loop 11" connects the left uppermost channel with the right second uppermost channel. Consequently, in the shoelaces configuration 44 the second channel loops are arranged to cross each other rather than having their ends connected to channels which are on a same level, as in the previous embodiments.

It is to be understood that the above description and the accompanying figures are only intended to illustrate the present invention. It will be obvious to a person skilled in the art that the invention can be varied and modified without departing from the scope of the invention.

**Claims**

1. A cooling apparatus (1, 31, 41) comprising:

   tubes (4) extending between a first end (6) and a second end (7) of the cooling apparatus, each tube (4) containing a plurality of channels (8) which are separated from each other by longitudinal internal walls (9) of the respective tube,
   a first manifold (2, 32, 42) in the first end (6) which provides a fluid path between predetermined channels of the tubes (4) in the first end, and
   a second manifold (3, 33, 43) in the second end (7) which provides a fluid path between predetermined channels (8) of the tubes (4) in the second end, and wherein
   the channels (8) have a capillary dimension to provide an orientation free cooling apparatus working as a pulsating heat pipe, **characterized in that**
   the first (2, 32, 42) and second (3, 33, 43) manifolds are solid blocks providing channel loops (10, 11, 34), and
   the channels (8) of the tubes (4) are connected by the channel loops (10, 11, 34) to other channels (8) of the tubes (4) to provide said fluid path between predetermined channels of the tubes in the first end (6) and in the second end (7).

2. The cooling apparatus according to claim 1, wherein the channel loops (10, 11, 34) have a constant cross-section and curvature.

3. The cooling apparatus according to claim 1 or 2, wherein a cross-section of a channel loop (10, 11) connecting to each other two channels (8) corresponds to the cross-section of the channels (8).

4. The cooling apparatus (31, 41) according to one of claims 1 to 3, wherein the first manifold (2, 32) and the second manifold (3, 33) have a symmetrical design with identical channel loops (10, 11).

5. The cooling apparatus (1) according to one of claims 1 to 4, wherein
   all channels (8) and all channel loops (10, 11) are connected in series to provide one single fluid path through the entire cooling apparatus (1).

6. The cooling apparatus (1) according to one of claims 1 to 5, wherein
   the first (2) and second (3) manifolds are provided with first channel loops (10) and second channel loops (11) such that:

> the first channel loops (10) provide a fluid path back and forth through the channels of each single tube (4), and
> the second channel loops (1) provide a fluid path from a last channel (12) on the fluid path of each single tube (14) to a first channel (13) on the fluid path of a subsequent single tube (15),
> a first end of a first channel of a first outermost tube (16) is plugged (17) in a first end (6) of the cooling apparatus (1), and
> a second end of a last channel of a second outermost tube (18) is plugged (17) in a second end (7) of the cooling apparatus (1).

**7.** The cooling apparatus (31) according to one of claims 1 to 4, wherein
the first (32) and second manifolds (33) are provided with second channel loops (11) providing a fluid path from each channel (8) of each tube (4) to one channel (8) of an adjacent tube (4), except for:

> a first outermost tube (16) where adjacent channels (8) of the tube are interconnected in the first manifold (32) by first channel loops (10) that provide a fluid path between two adjacent channels (8), and a third channel loop (34) that provides a fluid path between three adjacent channels (8), and
> a second outermost tube (18) where adjacent channels (8) of the tube are interconnected in the second manifold (33) by first channel loops (10) that provide a fluid path between two adjacent channels (8), and a third channel loop (34) that provides a fluid path between three adjacent channels (8).

**8.** The cooling apparatus (41) according to claim 1, wherein
the first (42) and second (43) manifolds are provided with second channel loops (11) providing a fluid path from each channel (8) of each tube (4) to one channel of an adjacent tube (4), except for
a first end of a first channel (8) of a first outermost tube (16) and a first end of a first channel (8) of a second outermost tube (18) which are plugged (17) in a first end (6) of the cooling apparatus.

**9.** The cooling apparatus (1, 31, 41) according to one of claims 1 to 8, wherein the cooling apparatus is provided with a base plate (27) including at least two layers (19, 20) of different materials, a material of a first layer (19) having a significantly better thermal conductivity than a material of a second layer (20), and the material of the second layer (20) having significantly better electrical insulation capabilities than the material of the first layer (19).

**10.** The cooling apparatus (1, 31, 41) according to one of claims 1 to 9, wherein the cooling apparatus is provided with a base plate (27) having a first surface (21) for receiving an electric component (22), and a second surface (23) which is opposite to the first surface (21) and which is provided with grooves (23) into which at least a part of the tubes (4) penetrate.

**11.** A method of manufacturing a cooling apparatus (1, 31, 41), comprising:

> providing tubes (4) having a plurality of channels (8) which are separated from each other by longitudinal internal walls (9), **characterized in that** the method additionally comprises:

>> manufacturing a first (2, 32, 42) and a second (3, 33, 43) manifold by 3D printing to be solid blocks that have channel loops (10, 11, 34), and
>> assembling the cooling apparatus by connecting channels (8) of the tubes (4) by the channel loops (10, 11, 34) of the first and second manifold to other predetermined channels (8) of the tubes (4).

**12.** The method according to claim 11, wherein
the first (2, 32, 42) and second (3, 33, 43) manifold are manufactured to solid blocks containing channel loops (10, 11, 34) having a smooth round shape and a dimension that corresponds to the dimension of the channels (8) in the tubes (8).

**13.** The method according to one of claims 9 to 12, wherein the first and second manifold are manufactured to have a first channel loop (10) providing a fluid path between channels of neighboring tubes (4) with an inter-spacing (D1) which is less than 8 mm.

**14.** The method according to one of claims 11 to 13, wherein the first (2, 32, 42) and second (3, 33, 43) manifold is manufactured by 3D printing a material containing at least aluminum.

**15.** The method according to one of claims 11 to 14, wherein the method comprises:

> manufacturing of a base plate (27) by 3D printing to include at least two layers of different materials, a material of the first layer (19) having a significantly better thermal conductivity than a material of the second layer (20), and the material of the second layer (20) having significantly better electrical insulation capabilities than the material of the first layer (19), and
> attaching said base plate (27) to tubes (4) of the cooling apparatus.

16. The method according to claim 15, wherein the base plate (27) is manufactured to have a first surface (21) for receiving an electrical component (22), and a second surface (23) which is opposite to the first surface and which is provided with grooves (24) dimensioned to receive at least a part of the tubes (4) when the base plate (27) is attached to the tubes (4).

FIG. 1

FIG. 2

FIG. 3

FIG. 4

FIG. 5

Europäisches
Patentamt

European
Patent Office

Office européen
des brevets

# EUROPEAN SEARCH REPORT

Application Number

EP 15 18 8764

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/211743 A1 (SCHRADER TIMOTHY J [US] ET AL) 27 August 2009 (2009-08-27) * paragraphs [0044] - [0060], [0078] - [0082] - paragraph [0060]; figures 1-10, 16A-17B * | 11,12,14 | INV. F28F9/02 F28D15/02 F28D15/04 F28F1/02 H05K7/20 |
| Y | EP 2 444 770 A1 (ABB RESEARCH LTD [CH]) 25 April 2012 (2012-04-25) * paragraph [0015] - paragraph [0040]; figures 1-6 * | 1-11 | |
| Y | JP 2003 166793 A (FUJINE SANGYO KK) 13 June 2003 (2003-06-13) * abstract; figures 1-6 * | 1-11 | |
| Y | WO 2014/202474 A1 (COMMISSARIAT ENERGIE ATOMIQUE [FR]; NOVADAY [FR]) 24 December 2014 (2014-12-24) * page 4, line 15 - page 12, line 10; figures 16-20 * | 7 | |
| A | EP 2 811 251 A1 (ABB RESEARCH LTD [CH]) 10 December 2014 (2014-12-10) * paragraph [0014] - paragraph [0031]; figures 1-4 * | 1-16 | TECHNICAL FIELDS SEARCHED (IPC) F28F F28D H05K |
| A | EP 2 327 947 A1 (ABB RESEARCH LTD [CH]) 1 June 2011 (2011-06-01) * paragraph [0020] - paragraph [0039]; figures 1-9 * | 1-16 | |
| A | EP 2 793 261 A1 (ABB OY [FI]) 22 October 2014 (2014-10-22) * paragraph [0014] - paragraph [0028]; figures 1-4 * | 1-16 | |
| | -/-- | | |

The present search report has been drawn up for all claims

| Place of search | Date of completion of the search | Examiner |
|---|---|---|
| The Hague | 24 March 2016 | Beltzung, Francis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 15 18 8764

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2006/042825 A1 (LU MINHUA [US] ET AL) 2 March 2006 (2006-03-02) * paragraph [0060] - paragraph [0076]; figures 5-13B * | 1-16 | |
| A | US 2013/194745 A1 (MEIJER INGMAR G [CH] ET AL) 1 August 2013 (2013-08-01) * paragraphs [0022], [0025]; figures 1,2 * | 1-16 | |
| A | US 5 704 415 A (SUZUKI MASAMICHI [JP] ET AL) 6 January 1998 (1998-01-06) * column 6, line 62 - column 7, line 54; figures 1-6 * | 1-16 | |
| A | US 2012/087088 A1 (KILLION JESSE DAVID [US] ET AL) 12 April 2012 (2012-04-12) * paragraphs [0093], [0204]; figures 7-7B * | 1-16 | |
| A | US 2010/032150 A1 (DETERMAN MATTHEW [US] ET AL) 11 February 2010 (2010-02-11) * paragraph [0054] - paragraph [0055]; figures 10,11 * | 1-16 | TECHNICAL FIELDS SEARCHED (IPC) |
| A | JP 2005 201600 A (FUJINE SANGYO KK) 28 July 2005 (2005-07-28) * abstract; figures 1-8 * | 1-16 | |
| A | JP 2004 020093 A (FUJINE SANGYO KK) 22 January 2004 (2004-01-22) * abstract; figures 1-10 * | 1-16 | |

The present search report has been drawn up for all claims

| Place of search | Date of completion of the search | Examiner |
|---|---|---|
| The Hague | 24 March 2016 | Beltzung, Francis |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 15 18 8764

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2016

| Patent document cited in search report | | Publication date | Patent family member(s) | | Publication date |
|---|---|---|---|---|---|
| US 2009211743 | A1 | 27-08-2009 | CN | 202013133 U | 19-10-2011 |
| | | | US | 2009211743 A1 | 27-08-2009 |
| | | | WO | 2009105454 A2 | 27-08-2009 |
| EP 2444770 | A1 | 25-04-2012 | CN | 102573407 A | 11-07-2012 |
| | | | EP | 2444770 A1 | 25-04-2012 |
| | | | US | 2012097369 A1 | 26-04-2012 |
| JP 2003166793 | A | 13-06-2003 | JP | 3511604 B2 | 29-03-2004 |
| | | | JP | 2003166793 A | 13-06-2003 |
| WO 2014202474 | A1 | 24-12-2014 | FR | 3007122 A1 | 19-12-2014 |
| | | | WO | 2014202474 A1 | 24-12-2014 |
| EP 2811251 | A1 | 10-12-2014 | CN | 104219934 A | 17-12-2014 |
| | | | EP | 2811251 A1 | 10-12-2014 |
| | | | US | 2014352927 A1 | 04-12-2014 |
| EP 2327947 | A1 | 01-06-2011 | AT | 546705 T | 15-03-2012 |
| | | | CN | 102083297 A | 01-06-2011 |
| | | | EP | 2327947 A1 | 01-06-2011 |
| | | | US | 2011127011 A1 | 02-06-2011 |
| EP 2793261 | A1 | 22-10-2014 | CN | 104114011 A | 22-10-2014 |
| | | | EP | 2793261 A1 | 22-10-2014 |
| | | | US | 2014313672 A1 | 23-10-2014 |
| US 2006042825 | A1 | 02-03-2006 | US | 2006042825 A1 | 02-03-2006 |
| | | | US | 2009008129 A1 | 08-01-2009 |
| | | | US | 2009008130 A1 | 08-01-2009 |
| | | | US | 2009011546 A1 | 08-01-2009 |
| | | | US | 2009011547 A1 | 08-01-2009 |
| US 2013194745 | A1 | 01-08-2013 | NONE | | |
| US 5704415 | A | 06-01-1998 | NONE | | |
| US 2012087088 | A1 | 12-04-2012 | NONE | | |
| US 2010032150 | A1 | 11-02-2010 | TW | 201014515 A | 01-04-2010 |
| | | | US | 2010032150 A1 | 11-02-2010 |
| | | | WO | 2010017091 A1 | 11-02-2010 |
| JP 2005201600 | A | 28-07-2005 | NONE | | |
| JP 2004020093 | A | 22-01-2004 | NONE | | |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 15 18 8764

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2016

| Patent document cited in search report | Publication date | Patent family member(s) | Publication date |
|---|---|---|---|
| | | | |

EPO FORM P0459

For more details about this annex : see Official Journal of the European Patent Office, No. 12/82